(19) **Europäisches Patentamt / European Patent Office / Office européen des brevets**

(11) **EP 2 439 497 B1**

(12) **EUROPEAN PATENT SPECIFICATION**

(45) Date of publication and mention
of the grant of the patent:
**04.03.2015 Bulletin 2015/10**

(51) Int Cl.:
*G01D 4/00* *(2006.01)*       *G01R 31/02* *(2006.01)*

(21) Application number: **11290266.3**

(22) Date of filing: **09.06.2011**

(54) **Detection of loss or malfunctions in electrical distribution networks**

Erkennung von Verlust oder Störungen in elektrischen Verteilungsnetzwerken

Détection de pertes ou de dysfonctionnements dans des réseaux de distribution électrique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.10.2010 EP 10290534**

(43) Date of publication of application:
**11.04.2012 Bulletin 2012/15**

(73) Proprietor: **ALCATEL LUCENT**
**92100 Boulogne-Billancourt (FR)**

(72) Inventors:
• **Stocker, Klaus Erwin**
**70567 Stuttgart (DE)**

• **Kopp, Dieter**
**75428 Illingen (DE)**

(74) Representative: **Wetzel, Emmanuelle**
**Alcatel-Lucent Deutschland AG**
**Intellectual Property & Standards**
**70430 Stuttgart (DE)**

(56) References cited:
**WO-A2-2009/063481       DE-A1- 3 233 647**
**DE-A1- 19 701 317       US-A1- 2005 251 339**
**US-A1- 2007 021 936**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to the field of power measurement.

Detection of non-technical loss of electrical energy is a problem for any electric utility. If electrical energy is lost due to fraudulent actions, e.g. by use of a connection to the network bypassing the respective electricity meter, it is very difficult for the utility to analyze the location of the theft as well as the time/duration as well as the value of the theft.

Although the awareness grows, there exist markets where more than 10 % of the provided energy is consumed by theft or without authorization, thereby causing a significant threat to revenues.

Even where accurate values, e.g. measured by smart meters, are available, it has not been possible to accurately detect the location, time and amount of an electrical energy theft.

Still further, it is difficult to provide legal proof of an electrical energy theft after it is detected.

Additionally, loss may also be an indication of malfunctions within different power distribution networks, such as on chip-level, apparatus level, isolated networks, e.g. within a vehicle, consumer networks within a plant or a household, or any other appropriate distribution network.

There exist solutions which are based on data mining and neural networks. However none of the known methods is accurate enough to provide an accurate indication of the location, time and amount of an electrical energy theft. The majority of these methods are based on comparisons with historical data and load profiles or others. These methods are in general only able to provide an indication that there is a fraudulent action while they do not provide an indication of the theft time and amount.

Furthermore, there exist solutions within a smart meter intended to detect direct manipulation of the meter itself. However, one such smart meter is not able to detect a bypass thereof.

Additionally one may compare measurements by a group of meters which are located in the point of delivery, i.e., within a certain feed, with the combined readings from the meters of the supplied consumers. However, since the load within a distribution network and the portions thereof varies neither the exact location nor the amount of an electrical energy theft can be determined.

US 2005/0251339 A1 describes methods and systems for monitoring a state of an environment. Sensors are distributed spatially within the environment, with each sensor measuring one of the measured parameters at its spatial location. A controller receives data collected from each of the sensors. The controller identifies the occurrence of an event at at least one of the sensors. The controller extracts derived parameters from the collected data. The controller determines a cross-correlation of the extracted parameters over the sensors. The controller identifies an abnormality in the environment from the determined cross-correlation.

WO 2009/063481 A2 describes a method and system for energy evaluation process, which includes receiving from an image capture device an image of a power usage reading device, and storing said image on a data storage device electronically coupled to a processing device. Said data storage device further comprises a plurality of instructions executable by said processing device. The image is processed to identify at least one indicia on said image, and said at least one indicia is analyzed to indicate the state of said power usage reading device. The analysis of the state of multiple such power usage reading devices at each level is collated to determine points or channels of power loss at various stages of power transmission and distribution.

DE 32 33 647 A1 describes a method for verifying leakage losses of a meshed conduit network. Conduit sub-networks are formed and at least one flow property is recorded and evaluated at fixed inspection points for the conduit sub-network at specified times over a (first) measuring period which is always the same. At least one further measuring period is chosen in addition to the first measuring period on the same day and the obtained measured values are compared both with one another and with measured values from other areas. The method is suitable for meshed drinking water conduit networks and also for other meshed conduit networks.

US 2007/0021936 A1 describes a system comprising a plurality of sensors disposed at predetermined locations in a fluid distribution network and a server receiving sensor data from the sensors indicative of at least one predetermined characteristic of flow through the network. The server compares the sensor data to stored data to determine an existence of a problem condition in the network and, when a problem condition is determined to exist, executing a predetermined response procedure.

Even if one would combine two or more of the different solutions, the resulting solution fails to provide an accurate indication of the location, time and amount of the theft.

It is therefore an object of an embodiment of the invention to provide a method which allows for providing an accurate detection of loss in electrical distribution networks.

The problem is solved by a method for detecting loss or malfunctions in an electrical distribution network. In a first step average measured voltage values and average measured current values associated with one or more points of supply within the electrical distribution network are received. In another step average measured voltage values and average measured current values associated with a plurality of points of consumption within the electrical distribution network are received. Based on said received average measured voltage values and average measured current values conductivity parameters are calculated. Thereafter, in a further step further average measured voltage values and average measured current values from said points of supply within the electrical distribution network are received. In another step further average measured voltage values and average measured current values from said points of consumption within the electrical distribution network are received. Thereafter said further received average measured voltages and average measured currents are analyzed using said calculated conductivity parameters to detect any deviation of measured current values from calculated current values with respect to a given point of consumption or point of supply.

In an embodiment of the invention the received average measured voltage values and average measured current values are averaged over a predetermined period of time.

In a further embodiment of the invention from the analysis of points is determining a location of loss is determined.

In yet another embodiment of the invention from the analysis of points an amount of loss is determined.

According to still another embodiment of the invention the calculation of conductivity parameters is based on an optimization method.

In a further embodiment the optimization method is selected from the group comprising Quasi Newton, Conjugated Gradient, Simplex Method, Fuzzy Logic, Evolution Methods.

In a still further embodiment of the invention based on said received further average measured voltage values and further average measured current values second conductivity parameters are calculated and by comparing said first conductivity parameters to said second conductivity parameters are analyzed.

According to yet another embodiment the result of the analysis can be visualized.

The problem is also solved by a system adapted for detecting loss or malfunctions in an electrical distribution network. The System comprises a first logical receiver adapted for receiving average measured voltage values and average measured current values associated with one or more points of supply within the electrical distribution network, and a second logical receiver for receiving average measured voltage values and average measured current values associated with a plurality of points of consumption within the electrical distribution network. Additionally said system comprises a Calculation Unit adapted for calculating conductivity parameters based on said received average measured voltage values and average associated with current values. Said first logical Receiver is further adapted for receiving further average measured voltage values and average measured current values associated with said points of supply within the electrical distribution network and said second logical Receiver is further adapted for receiving further measured average voltage values and average current values associated with said points of consumption within the electrical distribution network. Said Calculation Unit is further adapted for analyzing said further received average measured voltages and average measured currents using said calculated conductivity parameters to detect any deviations of measured current values from calculated current values with respect to a given point of consumption or point of supply. According to another embodiment of the invention the Calculation Unit is further adapted to average said received average measured voltage values and average measured current values over a predetermined period of time.

Still in a further embodiment according to the invention said Calculation Unit is further adapted for determining from the analysis of points a location of loss.

In yet another embodiment said Calculation Unit is further adapted for determining from the analysis of points an amount of loss.

According to a further embodiment according to the invention said Calculation Unit is further adapted for calculating of conductivity parameters based on an optimization method.

In a further embodiment of the invention the optimization method is selected from the group comprising Quasi Newton, Conjugated Gradient, Simplex Method, Fuzzy Logic, and Evolution Methods.

Still in another embodiment of the invention said Calculation Unit is further adapted for visualizing the result of the analysis.

In a still further embodiment of the invention said Calculation Unit is further adapted for calculating second conductivity parameters based on said received further average measured voltage values and further average measured current values calculating second conductivity parameters; and said Calculation Unit is further adapted for analyzing by comparing said first conductivity parameters to said second conductivity parameters.

Brief Description of the Figures

Some embodiments of apparatus and/or methods in accordance with embodiments of the present invention are now described, by way of example only, and with reference to the accompanying drawings, in which:

Figure 1 shows schematically an exemplary electrical distribution network,
Figure 2 shows schematically an equivalent circuit of the exemplary electrical distribution network of Figure 1,

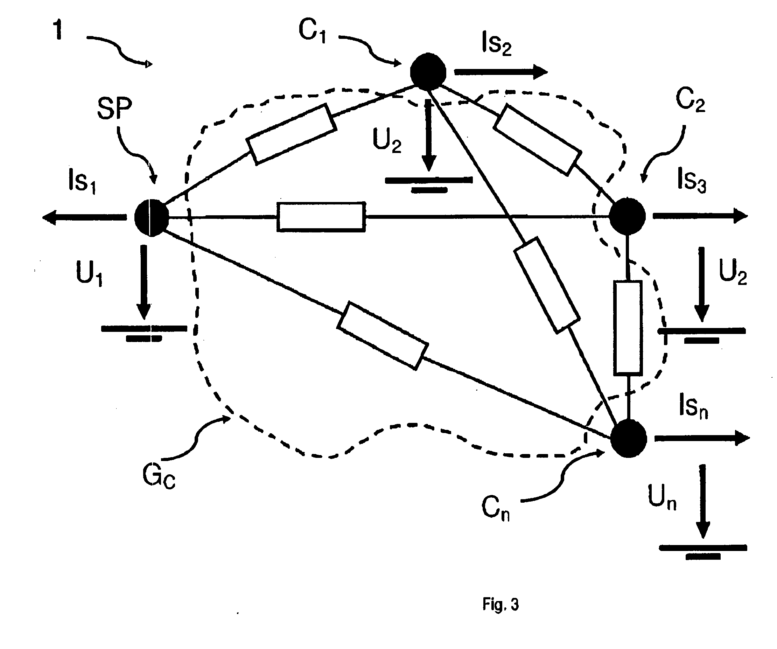

Figure 3 shows schematically an equivalent circuit of the exemplary electrical distribution network of Figure 1 being used within Detection,
Figure 4 shows a table of numerical results derived by a method according to an embodiment of the invention,
Figure 5 shows a graphical representation of numerical results derived by a method according to an embodiment of the invention,

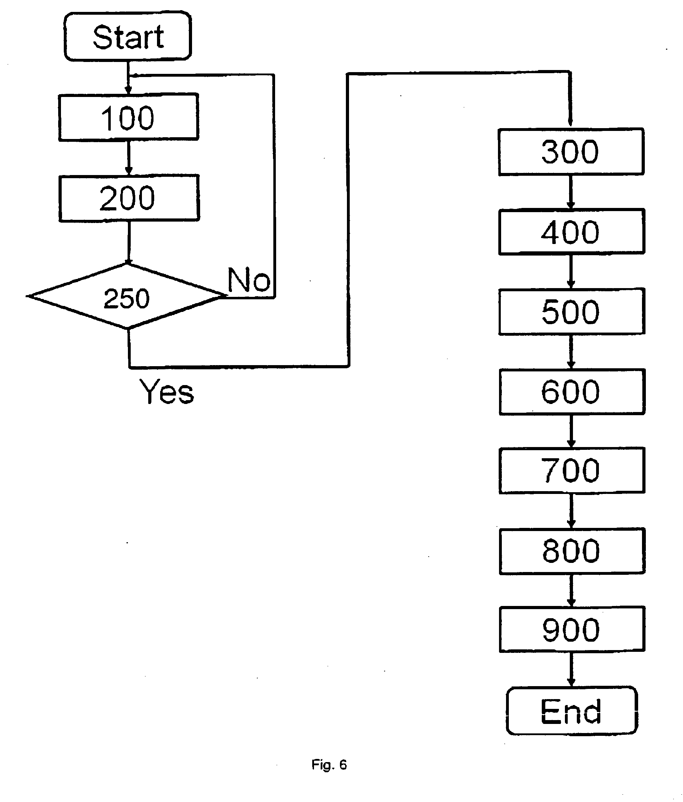

Figure 6 shows an exemplary flow diagram according to different embodiments of the invention,

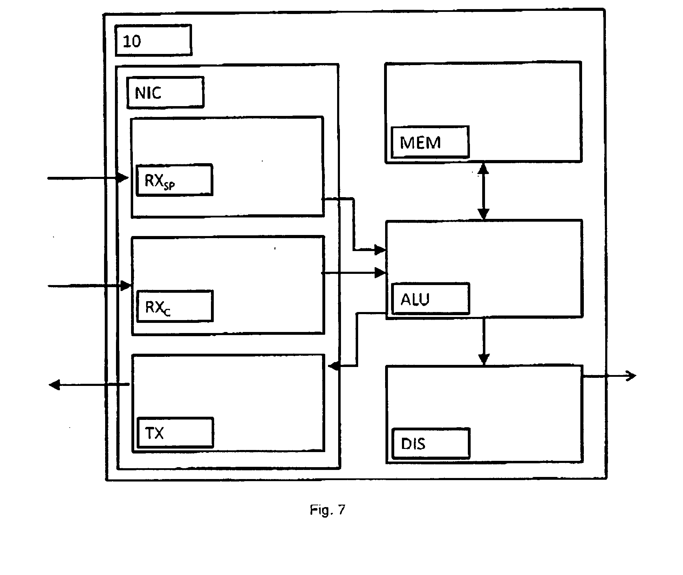

Figure 7 shows schematically exemplary system according to the invention,
Figure 8 shows a table of numerical results derived by a method according to an embodiment of the invention, and
Figure 9 shows a graphical representation of numerical results derived by a method according to an embodiment of the invention.

The following embodiments of the invention will be described with respect to the figures.

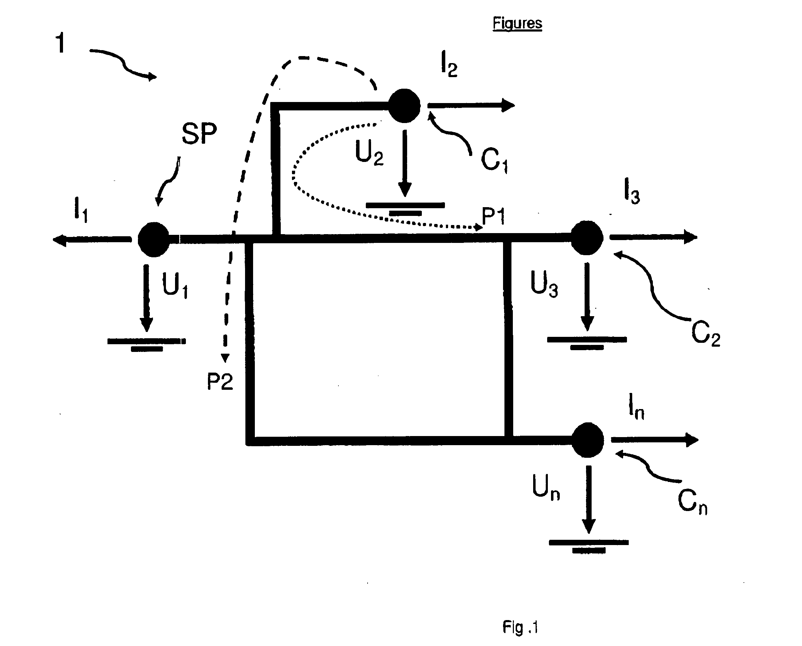

In Figure 1 an exemplary electrical distribution network 1 in one embodiment is shown.

Within said network 1, a power supplier SP is indicated on the right side of the figure. The power supplier SP delivers a current $I_1$ at a certain potential $U_1$ towards the network. Furthermore, said network 1 comprises a plurality of consumers $C_1$, $C_2$ --- and $C_n$, where n represents a predetermined integer.

Each Consumer consumes at a certain voltage (or potential difference) certain current. Said current may be understood as a measured current at a measured voltage. For example, Consumer $C_1$ consumes power which may be evaluated by the measured current $I_2$ and the measured voltage $U_2$, Consumer $C_2$ consumes power which may be evaluated by the measured current $I_3$ and the measured voltage $U_3$ and Consumer $C_n$ consumes power which may be evaluated by the measured current In and the measured voltage $U_n$.

Said network 1 may be meshed in any given arrangement as indicated in the Figure, i.e. it may even comprise loops, i.e. connections of different consumers via different pathes. I.e. Consumer C1 is interconnected to Consumer C2 or Cn via a first path P1 (dotted line) and via a second path P2 (dashed line).

Meshed network topologies are complex and do not allow for adopting solutions known to hierarchal organized networks.

The distribution network can be completely unknown in its topology and conductivity for the procedure.

Every load, be it consumption or supply, in the network leads to a negative or positive voltage drop that has an influence on the voltages in the whole network.

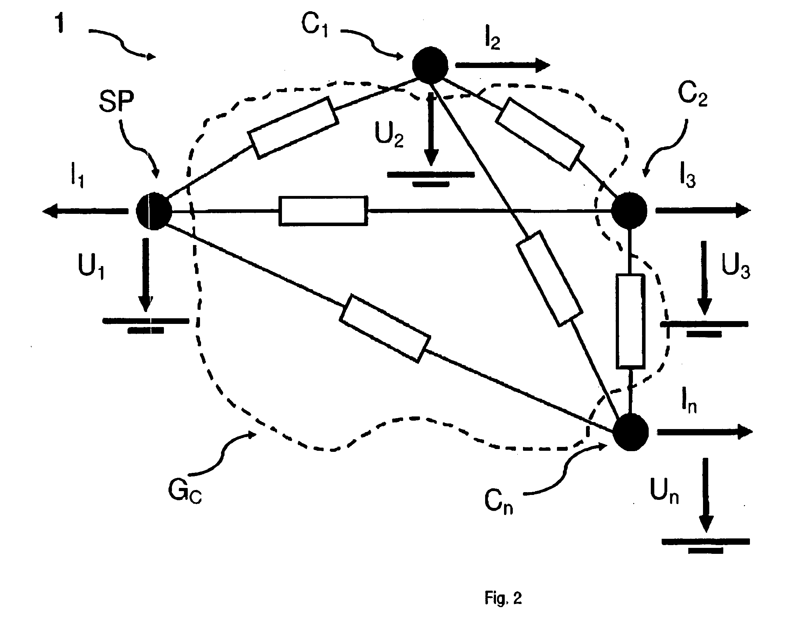

The network of Figure 1 and the associated loads may be described as a network of conductance as shown in Figure 2.

There, the plurality of consumers $C_1$, $C_2$ and $C_n$ and the Power Supplier SP are connected one another by certain conductance.

A consumer represents a point of consumption wile a power supplier represents a point of supply.

The network of conductance is represented by a dashed cloud $G_c$.

Within said network each supplier and each consumer measures the voltage and current. It is understood that these measured voltage and current may also be averages themselves, i.e, averages over a given period.

For convenience, and without loss of generality, it will be assumed in the following that the measured potential and currents are measured at the same time. If the measured potential and currents concern averages themselves it is assumed that they are as well averages with respect to the same time period, e.g. with respect to a certain amount of minutes, e.g. 1 min, 5 min, 15 min, 30 min, 60 min, ... .

Now, assuming that there is a conductance in each element - supplier(s) and consumer(s) - in the electrical distribution network 1, one can state, that there is a voltage drop across each element. Said voltage drop may be calculated in the following manner on basis of the measured value across each element of the electrical distribution network:

$$\delta U_{11} = U_1 - U_1$$
$$\vdots$$
$$\delta U_{1n} = U_1 - U_n$$

Based on the derived voltage drop, one may determine a simulated current through each element as follows:

$$Is_1 = g_{11} * \delta U_{11} + g_{12} * \delta U_{12} + \cdots g_{1n} * \delta U_{1n}$$
$$\vdots$$
$$Is_n = g_{n1} * \delta U_{n1} + g_{n2} * \delta U_{n2} + \cdots g_{nn} * \delta U_{nn}$$

where Is represents a simulated current through a network element.

In this instance, $Is_1$, represents a simulated current from the power supplier SP; $Is_2$ represents a simulated current to Consumer $C_1$, $Is_3$ represents a simulated current to Consumer $C_2$, and $Is_n$, represents a simulated current to Consumer $C_n$.

These simulated currents are based on the network of conductance expressed as a matrix as follows:

$$G_c = \begin{pmatrix} g_{11} & \cdots & g_{1n} \\ \vdots & \ddots & \vdots \\ g_{n1} & \cdots & g_{nn} \end{pmatrix}$$

The conductivity matrix $G_c$ is determined based on the following understanding:

$$Err(t) = \left(I_1 - Is_1\right)^2 + \cdots + \left(I_n - Is_n\right)^2$$

$$Err(t_1 \cdots t_k) = Err(t_1) + Err(t_2) + \cdots Err(t_k)$$

where $t_1 \ldots t_k$ indicates a time period.

It can be shown that the number of criteria provided by the two equations above needs to be sufficiently high such that the number of unknown matrix elements may be calculated.

The number of unknown matrix elements depends on the size of the network which impacts the coupling of matrix elements. I.e. the larger the network is the less impact is to expected from elements within the network elements which are distant to each other. This finding may be used to assume that a certain number of matrix elements are held to be 0, i.e. there is no need to determine these matrix elements.

Assuming a smaller network and, hence, a stronger coupling, the number of unknown matrix elements p may be determined as follows:

$$p = 0.5 * n * (n + 1),$$

where n is the number of criteria.

Assuming a larger network and, hence a looser coupling, the number of unknown matrix elements p may be defined as follows:

$$p < 0.5 * n * 50.$$

Here, the calculation is based on an estimated band matrix. As can be seen from the above, it is assumed that once a concerned network comprises more than 50 nodes, one may assume loose coupling. This estimation is a good assumption and reduces the overall necessary calculations. Nevertheless, if calculation time is of no concern, there is no necessity to assume loose coupling.

It can be shown that the number of criteria n given by equations Err (t) and Err ($t_1 \ldots t_k$) are equal to or higher than the number of unknown matrix elements p.

Per time period $t_1 \ldots t_k$, the number of criteria is n. By considering the above inequality p < 0.5*$n$*50 in case of loose coupling, one would need 25 time periods for the calculation of $G_c$.

The unknown matrix elements $g_{mn}$ are calculated using any appropriate optimization methods, such as Quasi Newton, Conjugated Gradient, Simplex Method, Fuzzy Logic, Evolution Methods, etc.

The optimization method may be chosen such that further parameters are taken into account such as time necessity and / or accuracy and / or efficiency.

It is understood that the intended target of the optimization is to minimize Err ($t_1 \ldots t_k$) to be as close to zero as possible by varying the matrix elements $g_{mn}$ until the intended target given is reached.

After the matrix is determined, the detection of loss may be performed.

The analysis of time and location is based on the following equations:

$$Err_1(t_1) = (I_1 - Is_1)^2$$
$$\vdots$$
$$Err_n(t_n) = (I_n - Is_n)^2$$

While the analysis on an amount of an electrical energy theft is based on the following equations:

$$If_n(t_1) = (I_1 - Is_1)$$
$$\vdots$$
$$If_n(t_n) = (I_n - Is_n)$$

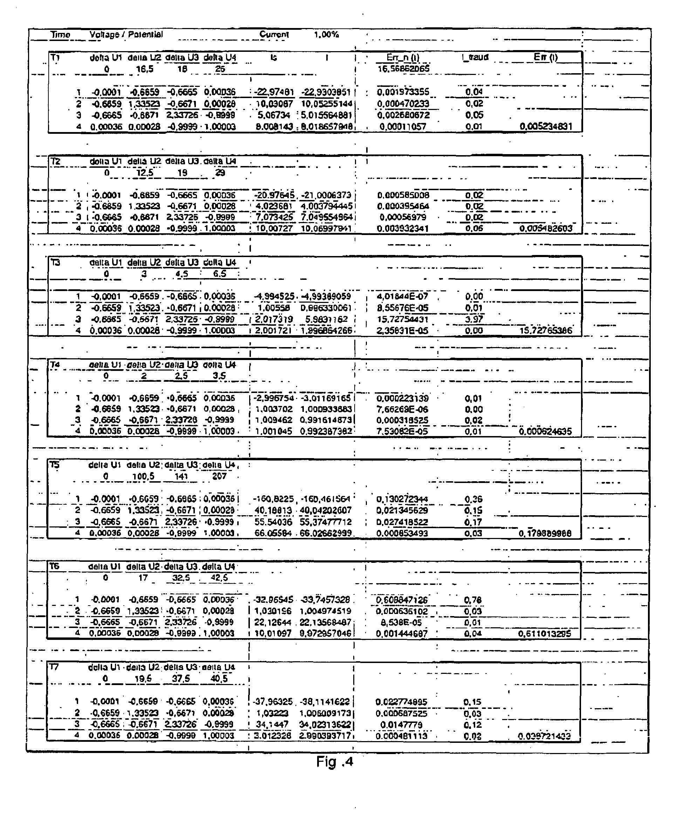

Now turning to a network comprising a Supplier SP and 3 Customers $C_1$, $C_2$ and $C_n$ as indicated in Figure 1, and assuming that the elements within the conductance matrix $G_c$ are already determined, it is assumed that the values displayed in the table shown in Figure 4 are received and further processed.

Within a first time period $T_1$ average currents and average voltage drops from the Supplier and the Customers are received. From these received values, the differential voltage drops $\delta U_{11}$ $\delta U_{1n}$ are determined as well as the simulated currents $Is_1 \ldots Is_n$, with respect to each supplier and consumer.

In theory, the simulated current and the measured current shall be identical. However, due to some numerical computation as well as varying voltages and varying load, a certain amount of deviation may be assumed as normal. In the present case it is assumed that a deviation within 5 % is within normalcy. This value may be subject to further fine tuning depending on numerical accuracy, time period for averaging, network size, etc.

The same is repeated for further time periods $T_2 \ldots T_7$.

Now turning to Time period $T_3$. There it can be seen that Consumer $C_2$ shows a deviation of more than 5 %. While the measured values leads to a simulated current $Is_2$ of 5,9831162, the measured current displays only 2,017319.

Hence, the above approach not only allows for detecting the location of a theft, customer 2, but also for quantifying the theft as almost 4 units within the time period $T_3$.

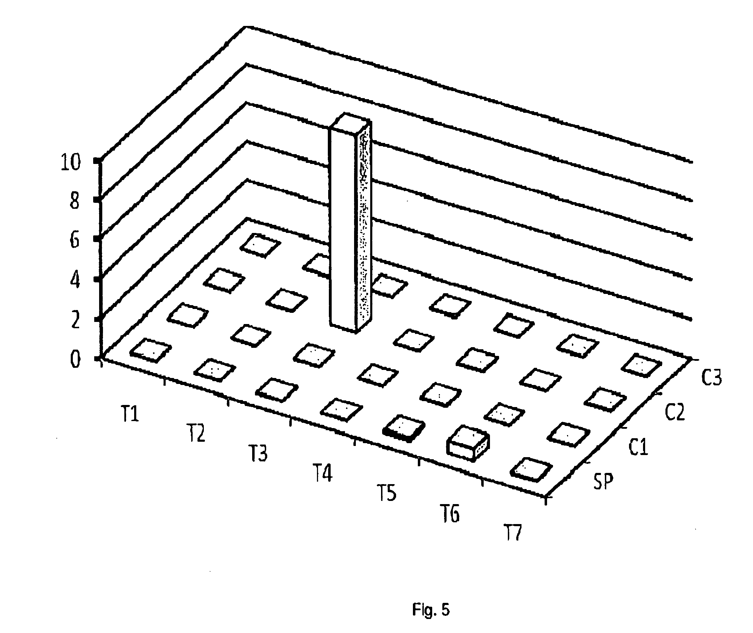

The results shown in the table may also be visualized in Figure 5. There it can easily be detected that within time period $T_3$ customer 2 has consumed more power than measured.

Thus an employee of the power distributor may easily detect the fraud and trigger a service employee to check the respective installation and / or to instigate legal actions. This may nevertheless also be automated and once a fraud is detected it would be possible to instruct services employees to check in an automated manner as well as instigating legal actions by means of a form letter.

Hence, a method according to the invention may be summarized as follows:

Average measured voltage values $U_1$ and average measured current values $I_1$, associated with one or more points of supply - such as supply locations - SP within the electrical distribution network 1 are received in a step 100.

In a further step 200 average measured voltage values $U_2, U_3, U_n$ and average measured current values $I_2, I_3, I_n$ associated with a plurality of points of consumption - such as all consumer locations - $C_1, C_2, C_n$ within the electrical distribution network 1 are received.

The steps 100 and 200 are repeated as long as necessary to provide enough criteria for calculating the matrix elements. Therefore, it is decided in a step 250 whether there are sufficient criteria available or not. If the number is not sufficient, the steps 100 and 200 are performed another time (No-branch) while if the number is sufficient, the method continues with step 300 (Yes-branch).

Based on said received average measured voltage values $U_1, U_2, U_3, U_n$ and average measured current values $I_1, I_2, I_3$, In first conductivity parameters of Matrix $G_c$ are calculated in a step 300.

Once the first conductivity parameters are determined further average measured voltage values $U_1$ and average current values $I_1$ associated with said points of supply SP within the electrical distribution network 1 are received in a step 400 and in a step 500 further average measured voltage values $U_2, U_3, U_n$ and average measured current values $I_2, I_3, I_n$ associated with said points of consumption $C_1, C_2, C_n$ within the electrical distribution network 1 are received.

Thereupon, said further received average measured voltages and average measured currents using said calculated first conductivity parameters are analyzed in step 600 to detect any deviation of measured current values from calculated current values with respect to a given point of consumption or point of supply.

It is understood that the calculation may need updates from time to time to reflect a varying electrical distribution network 1. The update may be triggered by construction works in the distribution network 1 and / or may be repeated periodically, e.g. every week, every month, etc. This update may lead to a periodical (re-)start of the method.

In an embodiment of the invention the received measured average voltage values and average current values are averaged over a predetermined period of time. A predetermined time may be any suitable time period, e.g. 1 min, 5 min, 15 min, 30 min, 60 min,

In an embodiment, the method may be complemented by a step 700 following analysis, said step concerning determination from the analysis of points a location of loss. This determination may be based on a certain threshold, i.e. once a certain threshold is exceeded the deviation is determined to be a theft. Such a threshold may be any suitable value, e.g. 5 %. Said value may be subject to further fine-tuning.

In still a further embodiment, the step of analyzing 600 may be followed by a step 800 in which it is determined from the analysis of points an amount of loss. This amount is based on the deviation of calculated and measured current values of the respective network element.

In a still further embodiment the calculation of conductivity parameters of step 300 is based on an optimization method. The unknown matrix elements $g_{mn}$ are calculated through any appropriate optimization methods, such as Quasi Newton, Conjugated Gradient, Simplex Method, Fuzzy Logic, Evolution Methods, etc.

In a still further embodiment the method also comprises a step 900 in which the results of the analysis provided in steps 600 and / or 700 and / or 800 are visualized.

Turning now to a different field of application, the invention may also be used for detection of malfunctions.

Malfunctions can be of two types, i,e, a quick degradation as it is experienced by a line cut or a short cut and slow degradation as it is experienced when lines or devices are showing a change in resistance e.g. due to aging processes.

Slow and quick as used herein are however not a fixed sizes but are connected to the methods and the repeated use.

Malfunctions lead to change in conductivity in between the concerned nodes. Suppose that Path P1 in Figure is damaged such that there is an increased resistance or that the line is completely interrupted.

A malfunction representing a quick degradation will be perceived as a change in error function in the process as described before. Quick in that sense may be within a small number of time periods compared to the number of time periods forming base of calculation of conductivity matrix. E.g. if the number of time periods necessary for calculating the conductivity matrix is 25 than a quick degradation may be within 10 or less time periods.

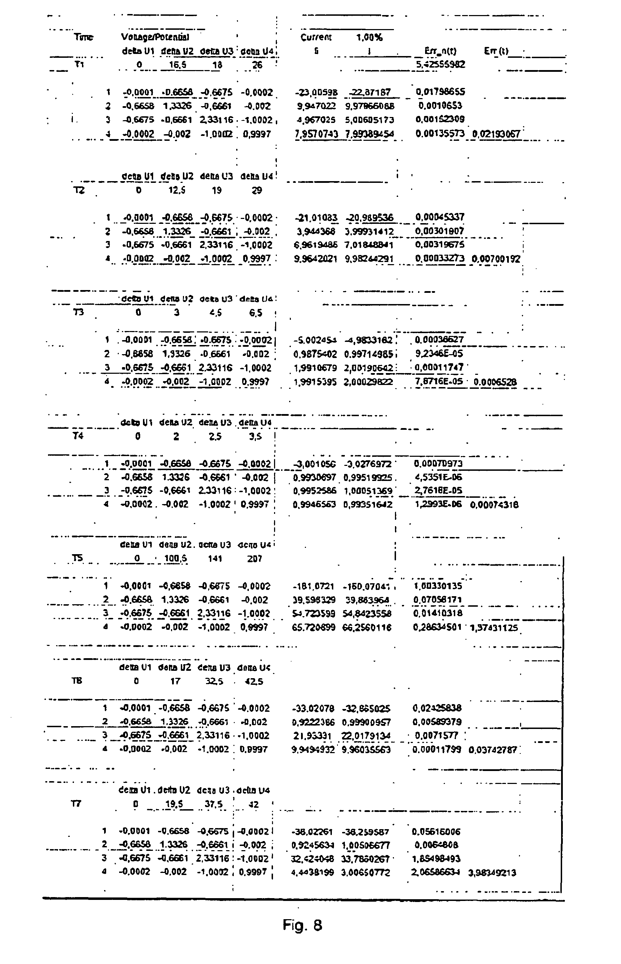

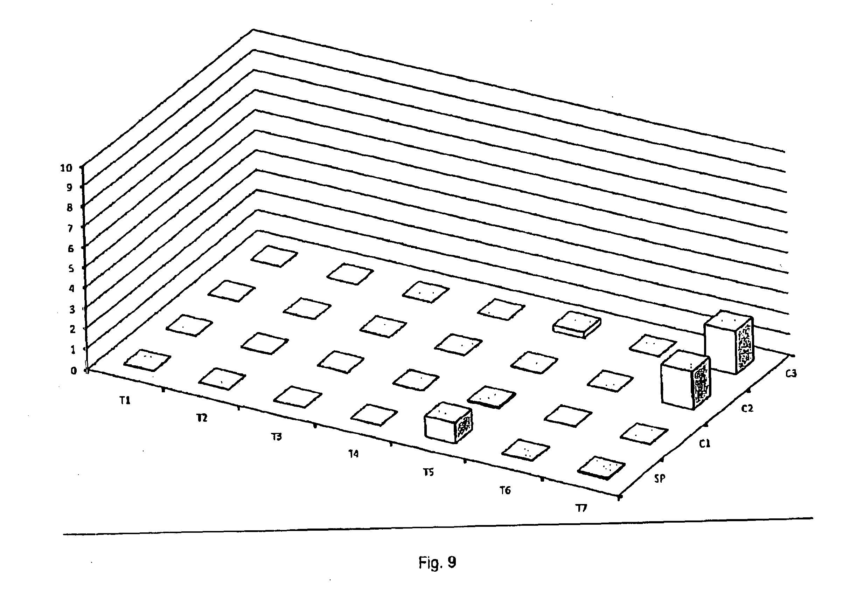

As can be seen in Figures 8 and 9 the deviations as derived in the process described before are rather low for different time periods $T_1$ to $T_6$. However, in time period $T_7$ at two nodes represented by Customer $C_2$ and $C_3$ almost the same deviation is experienced. As the deviation is not pertaining to a single customer but to two nodes, it may be deduced that the interconnection between Customer $C_2$ and $C_3$ is damaged, i.e. it experiences a fast degradation. This determination may be based on a certain threshold, i.e. once a certain threshold is exceeded the deviation is determined to be a theft. Such a threshold may be any suitable value, e.g. 5 %. Said value may be subject to further fine-tuning.

Hence, the analysis performed in step 600 may provide both an understanding were power is lost and an understanding were lines are malfunctioning due to fast degradation events.

However if the malfunction represents a slow degradation such as when a customer or a link in between customers and/or a supplier is aging leading to a slow change of resistance, the conductivity matrix $G_c$ will follow such a change and a malfunction representing a slow degradation may not be derivable via error functions. Slow in that sense may be within a certain number of time periods compared to the number of time periods forming base of calculation of conductivity matrix. E.g. if the number of time periods necessary for calculating the conductivity matrix is 25 than a slow degradation may be within 10 or more time periods. However, such a slow degradation can rather easily be detected by comparing conductivity matrixes over time.

Suppose a first matrix $G_{c.1}$ with first conductivity parameters is calculated at a point in time $t_1$ and another matrix $G_{c.2}$ with second conductivity parameters is calculated at a point in time $t_2$ which is different from $t_1$ than if no change in the distribution network is to be observed the conductivity matrix should almost be identical.

However, if the lines or a customer or a supplies experiences a slow degradation than the first and second conductivity parameters pertaining to a malfunctioning customer or supplier, and / or lines in between customer(s) and/or suppliers, will deviate over time.

Hence, by comparing conductivity matrixes respectively parameters pertaining to a second time period to previous ones, i.e. conductivity matrixes respectively parameters pertaining to a first time period, it is possible to detect even malfunctions representing slow degradations. This determination may be based on a certain threshold, i.e. once a certain threshold is exceeded the deviation is determined to be a theft. Such a threshold may be any suitable value, e.g. 5 %. Said value may be subject to further fine-tuning.

Obviously, detecting slow degradation may be performed stand alone as it is not necessary to calculate current values based on calculated conductivity parameters and received average measured voltages and average measured currents.

On the other hand it may easily be integrated as conductivity parameters calculation may be performed repeatedly.

In another embodiment of the invention, the above method is incorporated in a system 10 adapted for detecting loss in an electrical distribution network.

Such a system 10 may be embodied in a computer or a controller comprising a first iogicai receiver $RX_{SP}$ adapted for receiving average measured voltage values and average measured current values associated with one or more point of supply within the electrical distribution network, and a second logical Receiver $RX_c$ for receiving average measured voltage values and average measured current values associated with a plurality of points of consumption within the electrical distribution network 1.

Said logical receivers $RX_{SP}$ and $RX_c$ may be embodied in one or more network cards connected to respective meters located at the Supplier(s) SP and Customers $C_1$, $C_2$, $C_n$. As indicated said logical receivers $RX_{sp}$ and $RX_c$ may be embodied in a common physical Receiver NIC.

Said system 10 also comprises a Calculation Unit ALU adapted for calculating first conductivity parameters based on said received average measured voltage values and average measured current values. A respective Calculation Unit ALU may be any kind of a microprocessor, microcontroller, FPGA, ASIC, or the like.

Said first logical receiver $RX_{SP}$ is further adapted for Receiving further measured average voltage values and average current values associated with said points of supply SP within the electrical distribution network 1 and said second logical Receiver $RX_c$ is further adapted for Receiving further measured average voltage values and average current values associated with said points of consumption $C_1$, $C_2$, $C_n$ within the electrical distribution network 1.

Said logical receivers $RX_{sp}$ and $RX_c$ may be embodied in one or more network cards connected to respective meters located at the Supplier(s) SP and Customers $C_1$, $C_2$, $C_n$. As indicated said logical receivers $RX_{sp}$ and $RX_c$ may be embodied in a common physical Receiver NIC.

Said Calculation Unit ALU is further adapted for analyzing said further received average measured voltages and average measured currents using said calculated conductivity parameters to detect any deviation of measured current values from calculated current values with respect to a given point of consumption or point of supply.

If the ALU does not provide a memory sufficient for calculating, a conventional memory MEM may be provided which allows for storing of results, calculation intermediates and for retrieving said data, either for calculation and / or for displaying purposes, in particular, said memory may be arranged for storing one or more previously calculated conductivity parameter matrixes for detecting deviations pertaining to slow degradation of connections.

In a further embodiment of the invention the Calculation Unit ALU is further adapted to average said received measured average voltage values and average current values over a predetermined period of time.

In still a further embodiment of the invention, the Calculation Unit ALU is further adapted for determining from the analysis of points a location of loss.

In yet another embodiment of the invention the Calculation Unit ALU is further adapted for determining from the analysis of points an amount of loss.

According to another embodiment of the invention the Calculation Unit ALU is further adapted for calculating of conductivity parameters based on an optimization method. The optimization method is selected from the group comprising Quasi Newton, Conjugated Gradient, Simplex Method, Fuzzy Logic, and Evolution Methods.

In a further embodiment of the invention the Calculation Unit ALU is further adapted for calculating second conductivity parameters based on said received further average measured voltage values and further average measured current values calculating second conductivity parameters and the Calculation Unit ALU is further adapted for analyzing by comparing said first conductivity parameters to said second conductivity parameters.

It is however understood, that any appropriate method may be chosen. The optimization method may be chosen such that further parameters are taken into account such as time necessity and / or accuracy and / or efficiency.

The target of the optimization is to minimize Error, i.e. while calculating the matrix elements, the matrix elements are varied such that the difference between a measured current and a simulated current is minimized and eventually reaches 0, i.e. there is no error but the model is a true equivalent circuit of the electrical distribution network 1.

Still in another embodiment of the invention the Calculation Unit ALU is further adapted for visualizing the result of the analysis.

Such visualization may be performed by an internal WWW-Server which offers graphical data based on the calculations via a Transmitter TX of a network interface card NIC or it may be provided as a video-signal DIS directed to monitor.

By means of the invention it is now possible without knowing the exact network set-up of the distribution network to detect theft merely by receiving measured values and calculating. Thereby, it is not only achieved that the method is inexpensive but also that the method does not need special trained personnel.

The accuracy is highly increased by allowing detecting not only the time of theft but also detecting the location and amount of theft.

While the invention has been illustrated and described in detail in the drawings and foregoing description, such illustration and description are to be considered illustrative or exemplary and not restrictive; the invention is not limited to the disclosed embodiments.

Other variations to be disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

The present invention may be embodied in other specific apparatus and/or methods. The described embodiments are to be considered in all respects as only illustrative and not restrictive.

It should be appreciated by those skilled in the art that any block diagrams herein represent conceptual views of illustrative circuitry embodying the principles of the invention.

In particular, the scope of the invention is indicated by the appended claims rather than by the description and figures herein. All changes that come within the meaning and range of the claims are to be embraced within their scope.

## Claims

1. Method for detecting loss or malfunctions in a meshed electrical distribution network (1), comprising

 receiving average measured voltage values and average measured current values associated with one or more points of supply (SP) within the electrical distribution network (1);

 receiving average measured voltage values and average measured current values associated with a plurality of points of consumption ($C_1$, $C_2$, $C_n$) within the electrical distribution network (1);

 based on said received average measured voltage values and average measured current values calculating first conductivity parameters;

 receiving further average measured voltage values and average measured current values associated with said points of supply (SP) within the electrical distribution network (1);

 receiving further average measured voltage values and average measured current values from said points of consumption ($C_1$, $C_2$, $C_n$) within the electrical distribution network (1); and

 analyzing said further received average measured voltage values and average measured current values using said first calculated conductivity parameters to detect any deviations of measured current values from calculated current values with respect to a given point of consumption ($C_1$, $C_2$, $C_n$) or point of supply (SP).

2. Method according to claim 1, wherein the received average measured voltage values and average measured current values are averaged over a predetermined period of time.

3. Method according to claim 1 or 2, further comprising determining from the analysis of points ($C_1$, $Cz$, $C_n$, SP) a location of loss.

4. Method according to any of the preceding claims, further comprising determining from the analysis of points ($C_1$, $C_2$, $C_n$, SP) an amount of loss.

5. Method according to any of the preceding claims, wherein the calculation of conductivity parameters is based on an optimization method.

6. Method according to claim 5, wherein the optimization method is selected from the group comprising Quasi Newton, Conjugated Gradient, Simplex Method, Fuzzy Logic, Evolution Methods.

7. Method according to any of the preceding claims, further comprising visualizing the result of the analysis.

8. Method according to any of the preceding claims, further comprising the steps of

   • based on said received further average measured voltage values and further average measured current values calculating second conductivity parameters;
   • analyzing by comparing said first conductivity parameters to said second conductivity parameters.

9. System (10) adapted for detecting loss or malfunctions in a meshed electrical distribution network (1), comprising:

   a first logical receiver ($RX_{SP}$) adapted for receiving average measured voltage values and average current values associated with one or more points of supply (SP) within the electrical distribution network (1),
   a second logical receiver ($RX_C$) for receiving average measured voltage values and average measured current values associated with a plurality of points of consumption ($C_1$, $C_2$, $C_n$) within the electrical distribution network (1),
   a Calculation Unit (ALU) adapted for calculating first conductivity parameters based on said received average measured voltage values and average measured current values,
   wherein said first logical Receiver ($RX_{SP}$) is further adapted for receiving further average measured voltage values and average measured current values associated with said points of supply (SP) within the electrical distribution network (1),
   wherein said second logical Receiver ($RX_C$) is further adapted for receiving further average measured voltage values and average measured current values associated with said points of consumption ($C_1$, $C_2$, $C_n$) within the electrical distribution network (1),
   wherein said Calculation Unit (ALU) is further adapted for analyzing said further received average measured voltages and average measured currents using said calculated conductivity parameters to detect any deviation of measured current values from calculated current values with respect to a given point of consumption ($C_1$, $C_2$, $C_n$) or point of supply (SP).

10. System (10) according to claim 9, wherein the Calculation Unit (ALU) is further adapted to average said received average measured voltage values and average measured current values over a predetermined period of time.

11. System (10) according to claim 9 or 10, wherein said Calculation Unit (ALU) is further adapted for determining from the analysis of points ($C_1$, $C_2$, $C_n$, SP) a location of loss.

12. System (10) according to any of the preceding claims 9 to 11, wherein said Calculation Unit (ALU) is further adapted for determining from the analysis of points ($C_1$, $C_2$, $C_n$, SP) an amount of loss.

13. System (10) according to any of the preceding claims 9 to 12, wherein said Calculation Unit (ALU) is further adapted for calculating of conductivity parameters based on an optimization method.

14. System (10) according to claim 13, wherein the optimization method is selected from the group comprising Quasi Newton, Conjugated Gradient, Simplex Method, Fuzzy Logic, Evolution Methods.

15. System (10) according to any of the preceding claims 9 to 14, wherein said Calculation Unit (ALU) is further adapted for visualizing the result of the analysis.

16. System (10) according to any of the preceding claims 9 to 15,

   • wherein said Calculation Unit (ALU) is further adapted for calculating second conductivity parameters based on said received further average measured voltage values and further average measured current values calculating second conductivity parameters; and
   • wherein said Calculation Unit (ALU) is further adapted for analyzing by comparing said first conductivity parameters to said second conductivity parameters.

**Patentansprüche**

1. Verfahren zur Erkennung von Verlust oder Störungen in einem vermaschten Stromverteilungsnetzwerk (1), umfassend:

   Empfangen von mit einem oder mehreren Versorgungspunkten (SP) innerhalb des Stromverteilungsnetzwerks (1) assoziierten gemessenen Durchschnittsspannungswerten und gemessenen Durchschnittsstromwerten;
   Empfangen von mit einer Vielzahl von Verbrauchspunkten ($C_1$, $C_2$, $C_n$) innerhalb des Stromverteilungsnetzwerks (1) assoziierten gemessenen Durchschnittsspannungswerten und gemessenen Durchschnittsstromwerten;
   Berechnen, auf der Basis der empfangenen gemessenen Durchschnittsspannungswerte und gemessenen Durchschnittsstromwerte, von ersten Leitfähigkeitsparametern;
   Empfangen von mit den besagten Versorgungspunkten (SP) innerhalb des Stromverteilungsnetzwerks (1) assoziierten weiteren gemessenen Durchschnittsspannungswerten und gemessenen Durchschnittsstromwerten;
   Empfangen von weiteren gemessenen Durchschnittsspannungswerten und gemessenen Durchschnittsstromwerten von den besagten Verbrauchspunkten ($C_1$, $C_2$, $C_n$) innerhalb des Stromverteilungsnetzwerks (1); und
   Analysieren der besagten empfangenen weiteren gemessenen Durchschnittsspannungswerte und gemessenen Durchschnittsstromwerte unter Verwendung der besagten ersten berechneten Leitfähigkeitsparameter, um eventuelle Abweichungen der gemessenen Stromwerte von den berechneten Stromwerten in Bezug auf einen gegebenen Verbrauchspunkt ($C_1$, $C_2$, $C_n$) oder Versorgungspunkt (SP) zu erkennen.

2. Verfahren nach Anspruch 1, wobei die empfangenen gemessenen Durchschnittsspannungswerte und gemessenen Durchschnittsstromwerte über eine vorbestimmte Zeitspanne hinweg gemittelt werden.

3. Verfahren nach Anspruch 1 oder 2, weiterhin umfassend das Ermitteln einer Verluststelle ausgehend von der Analyse der Punkte ($C_1$, $C_2$, $C_n$, SP).

4. Verfahren nach einem beliebigen der vorstehenden Ansprüche, weiterhin umfassend das Ermitteln einer Verlustmenge ausgehend von der Analyse der Punkte ($C_1$, $C_2$, $C_n$, SP).

5. Verfahren nach einem beliebigen der vorstehenden Ansprüche, wobei die Berechnung der Leitfähigkeitsparameter auf einem Optimierungsverfahren basiert.

6. Verfahren nach Anspruch 5, wobei das Optimierungsverfahren aus einer Gruppe bestehend aus Quasi Newton, Konjugierter Gradient, Simplex-Verfahren, Fuzzylogik, Evolutionsverfahren ausgewählt wird.

7. Verfahren nach einem beliebigen der vorstehenden Ansprüche, weiterhin umfassend das Visualisieren des Ergebnisses der Analyse.

8. Verfahren nach einem beliebigen der vorstehenden Ansprüche, weiterhin die folgenden Schritte umfassend:

   • Berechnen, auf der Basis der besagten empfangenen weiteren gemessenen Durchschnittsspannungswerte und der weiteren gemessenen Durchschnittsstromwerte, von zweiten Leitfähigkeitsparametern;
   • Analysieren durch Vergleichen der besagten ersten Leitfähigkeitsparameter mit den besagten zweiten Leitfähigkeitsparametern.

9. System (10), ausgelegt für die Erkennung von Verlust oder Störungen in einem vermaschten Stromverteilungsnetzwerk (1), umfassend:

   Einen ersten logischen Empfänger ($RX_{SP}$), ausgelegt für den Empfang von mit einem oder mehreren Versorgungspunkten (SP) innerhalb des Stromverteilungsnetzwerks (1) assoziierten gemessenen Durchschnittsspannungswerten und gemessenen Durchschnittsstromwerten;
   einen zweiten logischen Empfänger ($RX_C$), ausgelegt für den Empfang von mit einer Vielzahl von Verbrauchspunkten ($C_1$, $C_2$, $C_n$) innerhalb des Stromverteilungsnetzwerks (1) assoziierten gemessenen Durchschnittsspannungswerten und gemessenen Durchschnittsstromwerten;
   eine Berechnungseinheit (ALU), ausgelegt für die Berechnung von ersten Leitfähigkeitsparametern auf der Basis der empfangenen gemessenen Durchschnittsspannungswerte und gemessenen Durchschnittsstromwerte;
   wobei der besagte erste logische Empfänger ($RX_{SP}$) weiterhin für den Empfang von mit den besagten Versorgungspunkten (SP) innerhalb des Stromverteilungsnetzwerks (1) assoziierten weiteren gemessenen Durchschnittsspannungswerten und gemessenen Durchschnittsstromwerten ausgelegt ist;
   wobei der besagte zweite logische Empfänger ($RX_C$) weiterhin für den Empfang von mit den besagten Verbrauchspunkten ($C_1$, $C_2$, $C_n$) innerhalb des Stromverteilungsnetzwerks (1) assoziierten weiteren gemessenen Durchschnittsspannungswerten und gemessenen Durchschnittsstromwerten ausgelegt ist;

wobei die besagte Berechnungseinheit (ALU) weiterhin für die Analyse der besagten empfangenen weiteren gemessenen Durchschnittsspannungswerte und gemessenen Durchschnittsstromwerte unter Verwendung der besagten berechneten Leitfähigkeitsparameter, um eventuelle Abweichungen der gemessenen Stromwerte von den berechneten Stromwerten in Bezug auf einen gegebenen Verbrauchspunkt ($C_1$, $C_2$, $C_n$) oder Versorgungspunkt (SP) zu erkennen, ausgelegt ist.

**10.** System (10) nach Anspruch 9, wobei die Berechnungseinheit (ALU) weiterhin für die Mittelung der besagten empfangenen gemessenen Durchschnittsspannungswerte und für die Mittelung der gemessenen Durchschnittsstromwerte über eine vorbestimmte Zeitspanne hinweg ausgelegt ist.

**11.** System (10) nach Anspruch 9 oder 10, wobei die besagte Berechnungseinheit (ALU) weiterhin für die Ermittlung einer Verluststelle ausgehend von der Analyse der Punkte ($C_1$, $C_2$, $C_n$, SP) ausgelegt ist.

**12.** System (10) nach einem beliebigen der vorstehenden Ansprüche 9 bis 11, wobei die besagte Berechnungseinheit (ALU) weiterhin für die Ermittlung einer Verlustmenge ausgehend von der Analyse der Punkte ($C_1$, $C_2$, $C_n$, SP) ausgelegt ist.

**13.** System (10) nach einem beliebigen der vorstehenden Ansprüche 9 bis 12, wobei die besagte Berechnungseinheit (ALU) weiterhin für die Berechnung der Leitfähigkeitsparameter auf der Basis eines Optimierungsverfahren ausgelegt ist.

**14.** System (10) nach Anspruch 13, wobei das Optimierungsverfahren aus einer Gruppe bestehend aus Quasi Newton, Konjugierter Gradient, Simplex-Verfahren, Fuzzylogik, Evolutionsverfahren ausgewählt wird.

**15.** System (10) nach einem beliebigen der vorstehenden Ansprüche 9 bis 14, wobei die besagte Berechnungseinheit (ALU) weiterhin für die Visualisierung des Ergebnisses der Analyse ausgelegt ist.

**16.** System (10) nach einem beliebigen der vorstehenden Ansprüche 9 bis 15,

   • wobei die besagte Berechnungseinheit (ALU) weiterhin für das Berechnen, auf der Basis der besagten empfangenen weiteren gemessenen Durchschnittsspannungswerte und der weiteren gemessenen Durchschnittsstromwerte, von zweiten Leitfähigkeitsparametern ausgelegt ist;
   • wobei die besagte Berechnungseinheit (ALU) weiterhin für das Analysieren durch Vergleichen der besagten ersten Leitfähigkeitsparameter mit den besagten zweiten Leitfähigkeitsparametern ausgelegt ist.

## Revendications

**1.** Procédé de détection de pertes ou de dysfonctionnements dans un réseau de distribution électrique maillé (1), comprenant les étapes suivantes
recevoir des valeurs de tension mesurées moyennes et des valeurs de courant mesurées moyennes associées à un ou plusieurs points d'alimentation (SP) dans le réseau de distribution électrique (1) ;
recevoir des valeurs de tension mesurées moyennes et des valeurs de courant mesurées moyennes associées à un ou plusieurs points de consommation ($C_1$, $C_2$, $C_n$) dans le réseau de distribution électrique (1) ;
sur la base desdites valeurs de tension mesurées moyennes reçues et desdites valeurs de courant mesurées moyennes reçues, calculer des premiers paramètres de conductivité ;
recevoir des valeurs de tension mesurées moyennes supplémentaires et des valeurs de courant mesurées moyennes supplémentaires associées auxdits points d'alimentation (SP) dans le réseau de distribution électrique (1) ;
recevoir des valeurs de tension mesurées moyennes supplémentaires et des valeurs de courant mesurées moyennes supplémentaires provenant desdits points de consommation ($C_1$, $C_2$, $C_n$) dans le réseau de distribution électrique (1) ; et
analyser lesdites valeurs de tension mesurées moyennes reçues supplémentaires et lesdites valeurs de courant mesurées moyennes reçues supplémentaires à l'aide desdits premiers paramètres de conductivité calculés afin de détecter tout écart des valeurs de courant mesurées à partir des valeurs de courant calculées par rapport à un point de consommation donné ($C_1$, $C_2$, $C_n$) ou à un point d'alimentation donné (SP).

**2.** Procédé selon la revendication 1, dans lequel la moyenne des valeurs de tension mesurées moyennes reçues et des valeurs de courant mesurées moyennes reçues est calculée sur une période prédéterminée.

**3.** Procédé selon la revendication 1 ou 2, comprenant en outre la détermination à partir de l'analyse des points ($C_1$, $C_2$, $C_n$, SP) d'une localisation de perte.

**4.** Procédé selon l'une quelconque des revendications précédentes, comprenant en outre la détermination à partir de l'analyse des points ($C_1$, $C_2$, $C_n$, SP) d'une quantité de perte.

**5.** Procédé selon l'une quelconque des revendications précédentes, dans lequel le calcul des paramètres de conductivité est basé sur une méthode d'optimisation.

**6.** Procédé selon la revendication 5, dans lequel la méthode d'optimisation est sélectionnée dans le groupe comprenant les méthodes quasi-Newton, des gradients conjugués, du simplexe, de logique floue et d'évolution.

**7.** Procédé selon l'une quelconque des revendications précédentes, comprenant en outre la visualisation du résultat de l'analyse.

**8.** Procédé selon l'une quelconque des revendications précédentes, comprenant en outre les étapes suivantes :

 • sur la base desdites valeurs de tension mesurées moyennes reçues supplémentaires et desdites valeurs de courant mesurées moyennes reçues supplémentaires, calculer des deuxièmes paramètres de conductivité ;
 • analyser en comparant lesdits premiers paramètres de conductivité auxdits deuxièmes paramètres de conductivité.

**9.** Système (10) adapté pour détecter des pertes ou des dysfonctionnements dans un réseau de distribution électrique maillé (1), comprenant :

 un premier récepteur logique ($RX_{SP}$) adapté pour recevoir des valeurs de tension mesurées moyennes et des valeurs de courant mesurées moyennes associées à un ou plusieurs points d'alimentation (SP) dans le réseau de distribution électrique (1),
 un deuxième récepteur logique ($RX_C$) pour recevoir des valeurs de tension mesurées moyennes et des valeurs de courant mesurées moyennes associées à une pluralité de points de consommation ($C_1$, $C_2$, $C_n$) dans le réseau de distribution électrique (1),
 une unité de calcul (ALU) adaptée pour calculer des premiers paramètres de conductivité sur la base desdites valeurs de tension mesurées moyennes reçues et desdites valeurs de courant mesurées moyennes reçues,
 dans lequel ledit premier récepteur logique ($RX_{SP}$) est en outre adapté pour recevoir des valeurs de tension mesurées moyennes supplémentaires et des valeurs de courant mesurées moyennes supplémentaires associées auxdits points d'alimentation (SP) dans le réseau de distribution électrique (1),
 dans lequel ledit deuxième récepteur logique ($RX_C$) est en outre adapté pour recevoir des valeurs de tension mesurées moyennes supplémentaires et des valeurs de courant mesurées moyennes supplémentaires associées auxdits points de consommation ($C_1$, $C_2$, $C_n$) dans le réseau de distribution électrique (1),
 dans lequel ladite unité de calcul (ALU) est en outre adaptée pour analyser lesdites tensions mesurées moyennes reçues supplémentaires et lesdits courants mesurés moyens reçus supplémentaires à l'aide desdits paramètres de conductivité calculés afin de détecter tout écart des valeurs de courant mesurées à partir des valeurs de courant calculées par rapport à un point de consommation donné ($C_1$, $C_2$, $C_n$) ou à un point d'alimentation donné (SP).

**10.** Système (10) selon la revendication 9, dans lequel l'unité de calcul (ALU) est en outre adaptée pour calculer la moyenne desdites valeurs de tension mesurées moyennes reçues et desdites valeurs de courant mesurées moyennes reçues sur une période prédéterminée.

**11.** Système (10) selon la revendication 9 ou 10, dans lequel ladite unité de calcul (ALU) est en outre adaptée pour déterminer à partir de l'analyse des points ($C_1$, $C_2$, $C_n$, SP) une localisation de perte.

**12.** Système (10) selon l'une quelconque des revendications précédentes 9 à 11, dans lequel ladite unité de calcul (ALU) est en outre adaptée pour déterminer à partir de l'analyse des points ($C_1$, $C_2$, $C_n$, SP) une quantité de perte.

**13.** Système (10) selon l'une quelconque des revendications précédentes 9 à 12, dans lequel ladite unité de calcul (ALU) est en outre adaptée pour calculer des paramètres de conductivité sur la base d'une méthode d'optimisation.

**14.** Système (10) selon la revendication 13, dans lequel la méthode d'optimisation est sélectionnée dans le groupe comprenant les méthodes quasi-Newton, des gradients conjugués, du simplexe, de logique floue et d'évolution.

**15.** Système (10) selon l'une quelconque des revendications précédentes 9 à 14, dans lequel ladite unité de calcul (ALU) est en outre adaptée pour visualiser le résultat de l'analyse.

**16.** Système (10) selon l'une quelconque des revendications 9 à 15,

 • dans lequel ladite unité de calcul (ALU) est en outre adaptée pour calculer des deuxièmes paramètres de conductivité sur la base desdites valeurs de tension mesurées moyennes reçues supplémentaires et desdites valeurs de courant mesurées moyennes reçues supplémentaires calculant des deuxièmes paramètres de conductivité ; et

• dans lequel ladite unité de calcul (ALU) est en outre adaptée pour analyser en comparant lesdits premiers paramètres de conductivité auxdits deuxièmes paramètres de conductivité.

Fig .1

EP 2 439 497 B1

Fig. 2

Fig. 3

EP 2 439 497 B1

| Time | Voltage / Potential | | | | Current | 1.00% | | | | |
|---|---|---|---|---|---|---|---|---|---|---|
| **T1** | dolta U1 | delta U2 | delta U3 | delta U4 | ls | I | | Err_n (l) | I_traud | Err (l) |
| | 0 | 16,5 | 18 | 26 | | | | 16,56862065 | | |
| 1 | -0,0001 | -0,6659 | -0,6665 | 0,00036 | -22,97481 | -22,9303851 | | 0,001973355 | 0,04 | |
| 2 | -0,6659 | 1,33523 | -0,6671 | 0,00028 | 10,03087 | 10,05255144 | | 0,000470233 | 0,02 | |
| 3 | -0,6665 | -0,6671 | 2,33726 | -0,9999 | 5,06734 | 5,015564881 | | 0,002680672 | 0,05 | |
| 4 | 0,00036 | 0,00028 | -0,9999 | 1,00003 | 8,008143 | 8,018657948 | | 0,00011057 | 0,01 | 0,005234831 |
| **T2** | dolta U1 | delta U2 | delta U3 | delta U4 | | | | | | |
| | 0 | 12,5 | 19 | 29 | | | | | | |
| 1 | -0,0001 | -0,6659 | -0,6665 | 0,00036 | -20,97645 | -21,0006373 | | 0,000585008 | 0,02 | |
| 2 | -0,6659 | 1,33523 | -0,6671 | 0,00028 | 4,023681 | 4,003794445 | | 0,000395464 | 0,02 | |
| 3 | -0,6665 | -0,6671 | 2,33726 | -0,9999 | 7,073425 | 7,049554964 | | 0,00056979 | 0,02 | |
| 4 | 0,00036 | 0,00028 | -0,9999 | 1,00003 | 10,00727 | 10,06997941 | | 0,003932341 | 0,06 | 0,005482603 |
| **T3** | delta U1 | delta U2 | delta U3 | dolta U4 | | | | | | |
| | 0 | 3 | 4,5 | 6,5 | | | | | | |
| 1 | -0,0001 | -0,6659 | -0,6665 | 0,00036 | -4,994525 | -4,99369059 | | 4,01844E-07 | 0,00 | |
| 2 | -0,6659 | 1,33523 | -0,6671 | 0,00028 | 1,00558 | 0,996330061 | | 8,55676E-05 | 0,01 | |
| 3 | -0,6665 | -0,6671 | 2,33726 | -0,9999 | 2,017319 | 5,9831162 | | 15,72754431 | 3,97 | |
| 4 | 0,00036 | 0,00028 | -0,9999 | 1,00003 | 2,001721 | 1,896864266 | | 2,35831E-05 | 0,00 | 15,72765386 |
| **T4** | delta U1 | delta U2 | delta U3 | dolta U4 | | | | | | |
| | 0 | 2 | 2,5 | 3,5 | | | | | | |
| 1 | -0,0001 | -0,6659 | -0,6665 | 0,00036 | -2,996754 | -3,01169165 | | 0,000223139 | 0,01 | |
| 2 | -0,6659 | 1,33523 | -0,6671 | 0,00028 | 1,003702 | 1,000933683 | | 7,66269E-06 | 0,00 | |
| 3 | -0,6665 | -0,6671 | 2,33726 | -0,9999 | 1,009462 | 0,991614873 | | 0,000318525 | 0,02 | |
| 4 | 0,00036 | 0,00028 | -0,9999 | 1,00003 | 1,001045 | 0,992387382 | | 7,53082E-05 | 0,01 | 0,000624635 |
| **T5** | delta U1 | delta U2 | delta U3 | delta U4 | | | | | | |
| | 0 | 100,5 | 141 | 207 | | | | | | |
| 1 | -0,0001 | -0,6659 | -0,6665 | 0,00036 | -160,8225 | -160,461564 | | 0,130272344 | 0,26 | |
| 2 | -0,6659 | 1,33523 | -0,6671 | 0,00028 | 40,18813 | 40,04202607 | | 0,021345629 | 0,15 | |
| 3 | -0,6665 | -0,6671 | 2,33726 | -0,9999 | 55,54036 | 55,37477712 | | 0,027418522 | 0,17 | |
| 4 | 0,00036 | 0,00028 | -0,9999 | 1,00003 | 66,05584 | 66,02662999 | | 0,000853493 | 0,03 | 0,179889988 |
| **T6** | delta U1 | delta U2 | delta U3 | delta U4 | | | | | | |
| | 0 | 17 | 32,5 | 42,5 | | | | | | |
| 1 | -0,0001 | -0,6659 | -0,6665 | 0,00036 | -32,96545 | -33,7457328 | | 0,608847126 | 0,78 | |
| 2 | -0,6659 | 1,33523 | -0,6671 | 0,00028 | 1,030156 | 1,004974519 | | 0,000636102 | 0,03 | |
| 3 | -0,6665 | -0,6671 | 2,33726 | -0,9999 | 22,12644 | 22,13568487 | | 8,538E-05 | 0,01 | |
| 4 | 0,00036 | 0,00028 | -0,9999 | 1,00003 | 10,01097 | 9,972357046 | | 0,001444687 | 0,04 | 0,611013295 |
| **T7** | dolta U1 | delta U2 | delta U3 | delta U4 | | | | | | |
| | 0 | 19,5 | 37,5 | 40,5 | | | | | | |
| 1 | -0,0001 | -0,6659 | -0,6665 | 0,00036 | -37,96325 | -38,1141622 | | 0,022774895 | 0,15 | |
| 2 | -0,6659 | 1,33523 | -0,6671 | 0,00028 | 1,03223 | 1,006009173 | | 0,000687525 | 0,03 | |
| 3 | -0,6665 | -0,6671 | 2,33726 | -0,9999 | 34,1447 | 34,02313622 | | 0,0147779 | 0,12 | |
| 4 | 0,00036 | 0,00028 | -0,9999 | 1,00003 | 3,012328 | 2,990393717 | | 0,000481113 | 0,02 | 0,039721433 |

Fig .4

17

Fig. 5

Fig. 6

Fig. 7

| Time | Voltage/Potential | | | | Current | 1,00% | | |
|---|---|---|---|---|---|---|---|---|
| | delta U1 | delta U2 | delta U3 | delta U4 | S | I | Err_n(t) | Err (t) |
| T1 | 0 | 16,5 | 18 | 26 | | | 5,42556982 | |
| 1 | -0,0001 | -0,6658 | -0,6675 | -0,0002 | -23,00598 | -22,87187 | 0,01798655 | |
| 2 | -0,6658 | 1,3326 | -0,6661 | -0,002 | 9,947022 | 9,97966068 | 0,0010653 | |
| 3 | -0,6675 | -0,6661 | 2,33116 | -1,0002 | 4,967025 | 5,00605173 | 0,00152309 | |
| 4 | -0,0002 | -0,002 | -1,0002 | 0,9997 | 7,9570743 | 7,99389454 | 0,00135573 | 0,02193067 |
| T2 | delta U1 | delta U2 | delta U3 | delta U4 | | | | |
| | 0 | 12,5 | 19 | 29 | | | | |
| 1 | -0,0001 | -0,6658 | -0,6675 | -0,0002 | -21,01083 | -20,989536 | 0,00045337 | |
| 2 | -0,6658 | 1,3326 | -0,6661 | -0,002 | 3,944368 | 3,99931412 | 0,00301807 | |
| 3 | -0,6675 | -0,6661 | 2,33116 | -1,0002 | 6,9619486 | 7,01848841 | 0,00319675 | |
| 4 | -0,0002 | -0,002 | -1,0002 | 0,9997 | 9,9642021 | 9,98244291 | 0,00033273 | 0,00700192 |
| T3 | delta U1 | delta U2 | delta U3 | delta U4 | | | | |
| | 0 | 3 | 4,5 | 6,5 | | | | |
| 1 | -0,0001 | -0,6658 | -0,6675 | -0,0002 | -5,002454 | -4,9833182 | 0,00036627 | |
| 2 | -0,8658 | 1,3326 | -0,6661 | -0,002 | 0,9875402 | 0,99714985 | 9,2346E-05 | |
| 3 | -0,6675 | -0,6661 | 2,33116 | -1,0002 | 1,9910679 | 2,00190642 | 0,00011747 | |
| 4 | -0,0002 | -0,002 | -1,0002 | 0,9997 | 1,9915395 | 2,00029822 | 7,8716E-05 | 0,0006528 |
| T4 | delta U1 | delta U2 | delta U3 | delta U4 | | | | |
| | 0 | 2 | 2,5 | 3,5 | | | | |
| 1 | -0,0001 | -0,6658 | -0,6675 | -0,0002 | -3,001056 | -3,0276972 | 0,00070973 | |
| 2 | -0,6658 | 1,3326 | -0,6661 | -0,002 | 0,9930697 | 0,99519925 | 4,5351E-06 | |
| 3 | -0,6675 | -0,6661 | 2,33116 | -1,0002 | 0,9952586 | 1,00051369 | 2,7618E-05 | |
| 4 | -0,0002 | -0,002 | -1,0002 | 0,9997 | 0,9946563 | 0,99351642 | 1,2993E-06 | 0,00074318 |
| T5 | delta U1 | delta U2 | delta U3 | delta U4 | | | | |
| | 0 | 100,5 | 141 | 207 | | | | |
| 1 | -0,0001 | -0,6658 | -0,6675 | -0,0002 | -181,0721 | -150,07047 | 1,00330135 | |
| 2 | -0,6658 | 1,3326 | -0,6661 | -0,002 | 39,596329 | 39,863964 | 0,07056171 | |
| 3 | -0,6675 | -0,6661 | 2,33116 | -1,0002 | 54,720599 | 54,8423558 | 0,01410318 | |
| 4 | -0,0002 | -0,002 | -1,0002 | 0,9997 | 65,720899 | 66,2560116 | 0,28634501 | 1,37431125 |
| T6 | delta U1 | delta U2 | delta U3 | delta U4 | | | | |
| | 0 | 17 | 32,5 | 42,5 | | | | |
| 1 | -0,0001 | -0,6658 | -0,6675 | -0,0002 | -33,02078 | -32,865025 | 0,02425838 | |
| 2 | -0,6658 | 1,3326 | -0,6661 | -0,002 | 0,9222386 | 0,99900957 | 0,00589379 | |
| 3 | -0,6675 | -0,6661 | 2,33116 | -1,0002 | 21,93331 | 22,0179134 | 0,0071577 | |
| 4 | -0,0002 | -0,002 | -1,0002 | 0,9997 | 9,9494932 | 9,96035563 | 0,00011799 | 0,03742787 |
| T7 | delta U1 | delta U2 | delta U3 | delta U4 | | | | |
| | 0 | 19,5 | 37,5 | 42 | | | | |
| 1 | -0,0001 | -0,6658 | -0,6675 | -0,0002 | -38,02261 | -38,259587 | 0,05616006 | |
| 2 | -0,6658 | 1,3326 | -0,6661 | -0,002 | 0,9245634 | 1,00506677 | 0,0064808 | |
| 3 | -0,6675 | -0,6661 | 2,33116 | -1,0002 | 32,424048 | 33,7860267 | 1,85498493 | |
| 4 | -0,0002 | -0,002 | -1,0002 | 0,9997 | 4,4438199 | 3,00650772 | 2,06586634 | 3,98349213 |

Fig. 8

Fig. 9

**EP 2 439 497 B1**